# EUROPEAN PATENT APPLICATION

(11) **EP 1 676 898 A2**
(43) Date of publication of application: **05.07.2006**
(21) Application number: 05027386.1
(22) Date of filing: 14.12.2005
(51) Int. Cl.: C09K 11/06

(54) **Novel red color emitting compounds and organic electroluminescent device using them**

(30) Priority: 30.12.2004 KR 2004116305
(71) Applicant: LG Electronics Inc., Yongdungpo-Gu Seoul 150-010 (KR)
(72) Inventor: Kim, Ki Dong, Daedeok-gu Daejeon 306-775 (KR)
(74) Representative: Wibbelmann, Jobst

(57) **Abstract**

The present invention relates to a novel red color emitting compound of formula (I), an organic electroluminescent device using the compound, and a method for manufacturing the device. The present invention also relates to a red organic electroluminescent emitting device having high chromaticity and high brightness by using the compounds of the following formula (I) having high luminescence efficiency; 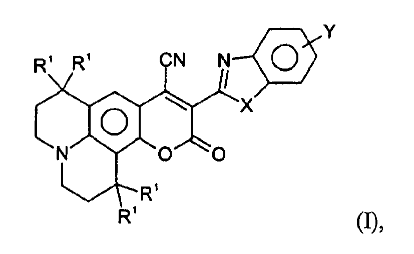 wherein R¹ is independently selected from the group consisting of hydrogen atom and substituted or unsubstituted C₁₋₆alkyl; X represents N, S, or O; and Y represents hydrogen atom, substituted or unsubstituted C₁₋₆alkyl, or substituted or unsubstituted C₁₋₆alkoxy.

## Description

### FIELD OF THE INVENTION

The present invention relates to novel red color emitting compounds, particularly to red color emitting compounds of the following formula (I) having good color purity and high luminescence efficiency: 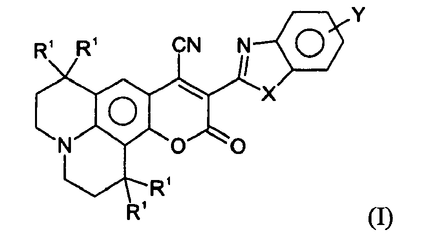 wherein,
R¹ is independently selected from the group consisting of hydrogen atom and substituted or unsubstituted C₁₋₆alkyl;
X represents N, S or O; and
Y represents a hydrogen atom, substituted or unsubstituted C₁₋₆alkyl, or substituted or unsubstituted C₁₋₆alkoxy.

The present invention also relates to an organic electroluminescent device containing said red color emitting compounds, particularly to an organic electroluminescent device having one or more organic thin layers comprising at least one luminescence region formed between a first electrode (an anode) and a second electrode (a cathode), wherein at least one layer of the organic thin layers comprises one or more compounds represented by the above formula (I).

### BACKGROUND OF THE INVENTION

Recently, in accordance with the development of information and communication technology, more advanced performance in the field of display devices has been requested. Displays can be divided into luminescent type and non-luminescent type. The luminescent type of display comprises Cathode Ray Tube (CRT), Electroluminescence Display (ELD), Light Emitting Diode (LED), Plasma Display Panel (PDP), etc. The non-luminescent type of display comprises Liquid Crystal Display (LCD), etc.

The luminescent and non-luminescent type of displays have such basic performances such as operation voltage, consumption power, brightness, contrast, response rate, lifetime, etc. However, LCD, which has been widely used up to now, has some problems in basic performances in regard to response rate, contrast, and sight dependency. Thus, displays using LED technology are anticipated to take the place of next-generation display devices by solving the above LCD problems and by providing many other advantages such as fast response speed, no need for back light due to self-emission, and excellent brightness.

However, LED is mainly used with a crystal form of inorganic material, and thus, is difficult to apply to a large size electroluminescent devices. In addition, electroluminescent devices using inorganic materials are very expensive and need more than 200 V of operation voltage. However, Eastman Kodak reported in 1987 that the company manufactured a device made of a material having a π-conjugate structure such as alumina quinine, and thereafter, the study for electroluminescent devices using organic material has been more active.

Electroluminescent devices (EL device, below) can be divided into inorganic EL devices and organic EL devices, depending on what material is used to form the emission layer (emitter layer).

The organic EL device, which is a self-emitting type of device that electrically excites a fluorescent organic compound, is superior to the inorganic EL device in brightness, operation voltage, and response rate, and also can emit multiple colors.

In addition, the organic EL device is a luminescent device that emits in a low voltage current, and has superior properties such as enhanced brightness, high speed of response, wide viewing angle, plane luminescence, slim type, and multicolor luminescence.

Thus, the organic EL device is expected to be applicable to a full-color plat panel display due to such superior properties that cannot be found in other displays.

C. W. Tang et al. reported the first practical device performance of the organic EL device in Applied Physics Letters, vol. 51 (12) pp 913-915 (1987). They developed a laminated-structure thin film (a hole transport layer) formed by diamine analogues as an organic layer and a thin film (an electron transport layer) formed by tris(8-quinolinolate)aluminum (Alq3, below). The laminated structure can lower the injection barrier of electron and hole from both electrodes to the organic layer, and also can enhance the re-combination probability of electron and hole from the inner organic layer.

Later, C. Adachi et al. developed an organic EL device having an organic luminescent layer with a three-layer laminated structure of hole transport layer, emission layer, and electron transport layer [Japanese Journal of Applied Physics, vol. 27 (2), pp L269-L271 (1988)], and a two-layer laminated structure of hole transportable emission layer and electron transport layer [Applied Physics Letter, vol. 55 (15), pp 1489-1491 (1989)], and showed that the optimization of device properties can be achieved by constructing a multi-layer structure suitable for materials and combinations thereof.

The organic EL comprises a first electrode (anode), a second electrode (cathode), and organic luminescent media. The organic luminescent media have at least two separate organic luminescent layers, i.e. one layer to inject and transport electrons, and the other layer to inject and transport holes into the device. In addition, another multi-layer of a thin organic film can be involved. The above layers to inject and transport electrons and holes can each be divided into an electron injection layer, an electron transport layer, a hole injection layer, and a hole transport layer. In addition, the organic luminescent media can further include an emission layer besides the above layers.

The simple structure of an organic EL device comprises a first electrode / an electron transport layer, an emission layer / a second electrode. In addition, the structure of an organic EL device can be separated into a first electrode / a hole injection layer / a hole transport layer / an emission layer / an electron transport layer / an electron injection layer / a second electrode. A hole blocking layer may optionally be used between the emission layer and the electron transport layer.

The operation principle of the organic EL device having the above structure is as follows.

If voltage is applied to the anode and cathode, a hole injected from the anode is transferred to the emission layer via the hole transport layer. Meanwhile, the electron is injected from the cathode to the emission layer via the electron transport layer. The hole and the electron are re-combined in the emission layer to form an exiton. The exiton is changed from the excitation state to the basic state, by which the fluorescent molecule of the emission layer becomes luminescent to form images.

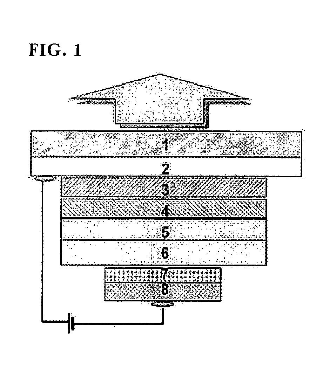

The manufacturing process of a conventional organic EL device is explained with referring to FIG. 1 as follows.

First of all, a first electrode (an anode) material **2** is formed on a transparent substrate such as glass **1**. Indium Tin Oxide (ITO: In₂O₃+SnO₂) may be generally used as the anode material **2**. A hole injection layer (HIL) **3** is formed on the anode material **2**. Copper (II) Phthalocyanine (CuPC) of a thickness of 0 to 30 nm may be generally used as HIL **3**.

Next, a hole transport layer (HTL) **4** is formed. And N,N-di(naphthalen-1-yl)-N,N'-diphenylbenzidine (NPD) of a thickness of about 30 to 60 nm may be generally used as HTL **4**.

Then, an organic emission layer **5** is formed on the HTL **4**. Particularly, the luminescent material may be used alone as the emission layer **5**, or used by doping a small quantity of impurity to the host material according to circumstances. For example, in case of green color emitting, tris(8-hydroxyquinolate) aluminum (Alq3) of a thickness of about 30 to 60 nm may be used as a host, and MQD (N-methylquinacridone) may be used as a dopant of the organic emission layer **5**.

Next, an electron transport layer **6** or an electron injection layer **7** is independently or subsequently formed on the emission layer **5**. Alq3 may be used as the electron transport layer in a thickness of about 20 to 50 nm, and an alkali metal analogue is used as the electron injection layer in a thickness of about 30 to 50 nm. In the case of green color emission, since Alq3 used as the organic emission layer has superior electron transport ability, the electron transport layer **6** or the electron injection layer **7** need not necessarily be used.

Further, a second electrode (cathode) **8** is formed on the electron injection layer **7**, and a protecting layer may be formed as a last layer.

Three luminescent devices emitting green, red and blue colors are usually needed to actualize the full color of the organic EL device.

The blue color is actualized by doping a blue color emitting dopant onto a blue color emitting host and using Alq3 as the electron transport layer, and Alq3 may be omitted depending on the properties of the blue host. In the case of a red color emitting device, a red wavelength can be obtained by doping a red color emitting dopant, instead of a green color emitting dopant, during the above preparation of the device.

In the case of a green color emitting device, Coumarine 6 or Quinacridone analogue is used as a dopant, and in the case of a red color emitting device, a DCM (4-dicyanomethylene-6-(p-dimethylaminostylyl)-2-methyl-4H-pyrnae) analogue, such as DCM1 or DCM2, etc., may be used as a dopant [see, Journal of Applied Physics, 3610 (1989)].

However, in the case of a green color emitting device, the safety of the device is evaluated to have reached a practical level, but the red color emitting device has a problem that the luminescent color and the safety of the device have not reached such a level.

That is, among the three luminescent devices of red/green/blue, the development of a red color emitting device has been last, and sufficient brightness and chromaticity therefor could not yet be obtained. For example, the peak wavelength of luminescent spectrum of the above DCM is about 600 nm, and the half band width is as broad as about 100 nm, therefore, the chromaticity as red corresponding to full-color is greatly lowered. In addition, if the concentration of the red color emitting dopant such as DCM is small, an orange region spectrum is obtained, and if that concentration is high, the red region is emitting but the luminescent efficiency is lowered by self-quenching. Further, a red color emitting device using Alq3 [tris(8-hydroxy quinolate)aluminum] doped by DCJTB [4-(Dicyanomethylene)-2-tert-butyl-6-(tetramethyljulolidi-4-yl)-4H-pyran] as an electron transport material is not satisfactory as a display material in view of brightness and chromaticity.

However, organic metal complexes whose central metal is europium, have been known as red color emitting devices having high chromaticity, but the maximum brightness of the organic EL device using them is very low [see, Applied Physics Letter, 65 (17), 2124~2126 (1994)].

In addition, Japanese Patent Publication No. 1999-329731 disclosed the manufacture of a red color emitting organic EL device having a high brightness by using specific di-styryl compounds. However, the half band width of luminescent spectrum is more than 100 nm, and thus its chromaticity cannot be said to be complete.

To solve the above problems, the present inventors have conducted intensive studies to develop a red color emitting material that is safe at a high brightness and has good chromaticity.

### SUMMARY OF THE INVENTION

One embodiment of the present invention is to provide a novel red color emitting material having high luminescence efficiency, high red chromaticity, and high brightness.

Another embodiment of the present invention is to provide an organic electroluminescent device comprising said red emitting material, which has high brightness and high luminescence efficiency.

Therefore, an embodiment of the present invention provides for red color emitting compounds represented by the following formula (I): 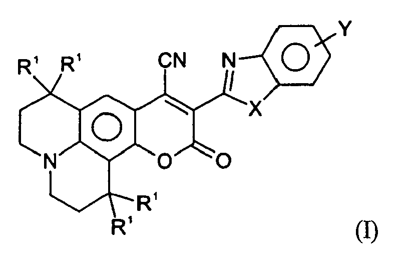 wherein
R¹ is independently selected from the group consisting of hydrogen atom and substituted or unsubstituted C₁₋₆alkyl;
X represents N, S, or O; and
Y represents hydrogen atom, substituted or unsubstituted C₁₋₆alkyl, or substituted or unsubstituted C₁₋₆alkoxy.

In one embodiment, R¹ represents a hydrogen atom or C₁₋₆alkyl, X represents N, S or O, and Y represents a hydrogen atom, C₁₋₆alkyl, or C₁₋₆alkoxy. In an embodiment of the present invention, in the compound according to formula (I), R¹ is methyl. In another embodiment, X is S. In yet another embodiment, Y is methyl. And, in yet another embodiment, R¹ is methyl, X is S, and Y is hydrogen or methyl. In one embodiment, the compound is a red color emitting material.

One embodiment of the present invention also provides for an organic electroluminescent device, comprising: a first electrode; a second electrode opposing the first electrode; and at least one organic layer located between the first electrode and the second electrode, wherein the at least one organic layer comprises at least one compound according to formula (I) above. In one embodiment, the at least one organic layer comprises a light-emitting layer. In another embodiment, the at least one organic layer is located between an anode that injects holes and a cathode that injects electrons. In yet another embodiment, one or more compound represented by formula (I) is used as a dopant and/or a host material.

According to the present organic electroluminescent device, the device may comprise the following a substrate, an anode over the substrate, a hole injection layer over the anode, a hole transportation layer over the hole injection layer, an emitting layer over the transportation layer, an electron transporting layer over the emitting layer and a cathode over the electron transporting layer; wherein a compound of formula (I) is contained in at least the emitting layer.

In yet another embodiment, the present invention provides for a method of manufacturing an organic electroluminescent device, comprising: (a) providing a substrate; (b) forming a first electrode; (c) forming at least one layer on the first electrode, the at least one layer comprising a compound of formula (I) above; and (d) forming a second electrode on the at least one layer comprising the compound of formula (I).

### BRIEF DESCRIPTION OF THE DRAWINGS

The present invention will be more clearly understood from the detailed description in conjunction with the following drawings.

FIG. 1 is a schematic sectional view of the conventional organic electroluminescent emitting device.

### DETAILED DESCRIPTON OF THE INVENTION

Hereinafter, the embodiments of the present invention will be described in detail with reference to those accompanying drawings.

The present invention provides red color emitting compounds represented by the following formula (I): 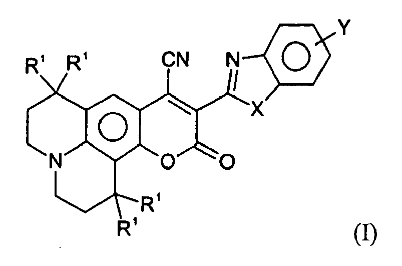 wherein
R¹ is independently selected from the group consisting of hydrogen atom and substituted or unsubstituted C₁₋₆alkyl;
X represents N, S, or O ; and
Y represents hydrogen atom, substituted or unsubstituted C₁₋₆alkyl, or substituted or unsubstituted C₁₋₆alkoxy.

### Preferred Embodiments of the Invention

Each definition in the above formula will be shown in detail below.

According to the present invention, "C₁₋₆alkyl group" means a straight or branched chain saturated hydrocarbon group having 1 to 6 carbon atoms, for example, methyl, ethyl, propyl, isopropyl, butyl, isobutyl, t-butyl, pentyl, isopentyl, hexyl, isohexyl group, etc., preferably methyl group or ethyl group, more preferably methyl group.

Also, "C₁₋₆alkoxy group" means a group containing a straight or branched alkyl having 1 to 6 carbon atoms, for example, methoxy, ethoxy, propoxy, isopropoxy, butoxy, isobutoxy, t-butoxy, pentoxy, isopentoxy, hexoxy, etc., preferably methoxy group or ethoxy.

When "substituted", whether a substituted C₁₋₆alkyl group, or a substituted C₁₋₆alkoxy group, the substituents may be selected from the group consisting of hydroxy and halogen.

The representative examples of compounds of formula (I) are described below. However, the present invention shall not be limited by these representative examples.

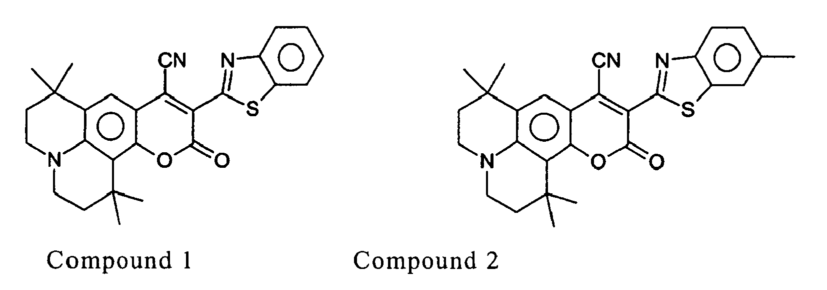

The compounds of formula (I) in the present invention may be prepared by methods known in the art. For example, Compound 1 according to the present invention is prepared by the following method (shown as Scheme 1). 2-aminophenol and calcium carbonate are dissolved in dimethylformamide, following by addition of 1-chloro-3-methyl-2-butene to prepare a compound of formula (2). Adding methanesulfonic acid to the compound of formula (2), the solution is stirred, following by neutralizing the solution using NaOH (sodium hydroxide) to obtain a compound of formula (3). And then, phosphorus oxychloride and dimethyl formamide are added to the obtained compound of formula (3) to obtain a compound of formula (4). After that, the compound of formula (4) and a compound of formula (5) (2-acetonitrile-benzotriazole) are added to ethanol with piperidine and the solution is stirred. ,After confirming that the reaction is completed by the TLC (thin layer chromatography), the solution is neutralized by using a suitable amount of HCl to obtain a compound of formula (6). And then, the compound of formula (6) is dissolved in water, and NaOH is added to the solution following by stirring to obtain a compound of formula (7). And then, NaCN (sodium cyanide), Br₂, and DMF(dimethyl formamide) are added to the compound of formula (7), and reacted to obtain the above Compound 1. This method may be changed by known methods in the art, and the compounds used and reaction conditions may be easily changed by the skilled person in the art to use a chemical preparing method known in the art.

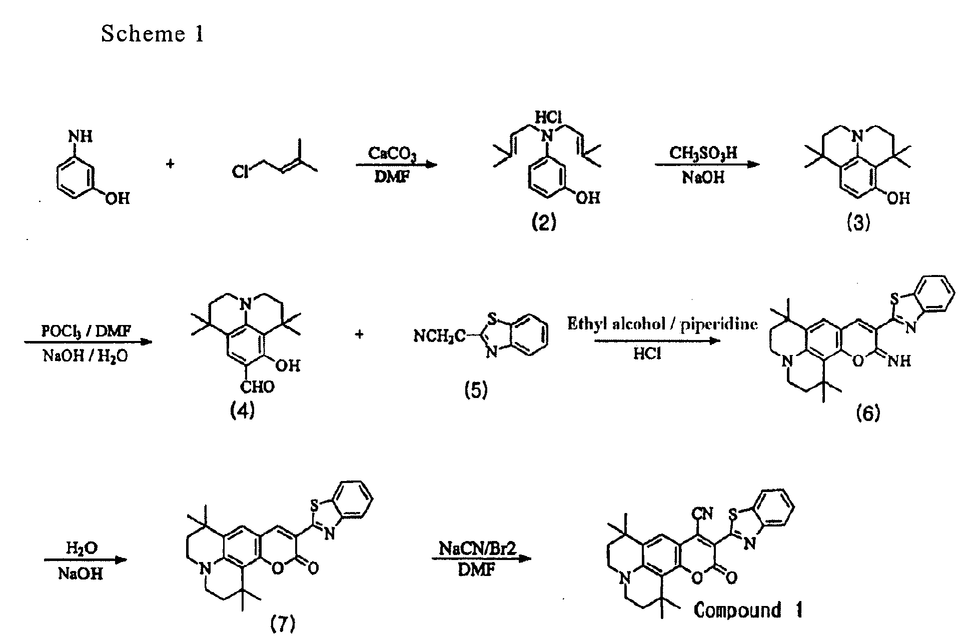

The compounds of formula (I) according to the above present invention may be used as a red color emitting material, specifically, used to provide a red color organic electroluminescent (EL) device.

The present invention provides an organic EL device comprising a compound of formula (I), more specifically, an organic EL device having one or more organic thin layers formed between the first electrode (anode) and the second electrode (cathode), wherein at least one layer of the organic thin layers comprises one or more red color emitting materials according to the present invention.

The compounds of formula (I) can be used alone, in a type of combination, or as a host doped by other materials, in any of the organic thin layers, or used as a dopant to other hole transport material, emission material, electron transport material, etc. Preferably, the compounds of the present invention are used as dopant or host to the emission layer.

A variety of embodiments of the organic EL device using the red color emitting materials of the present invention can be achieved. Basically, the emission layer, if necessary, is introduced between the pair of electrodes (anode and cathode). Then, if necessary, a hole injection layer and/or a hole transport layer and/or an electron injection layer and/or an electron transport layer can be introduced. Non-limiting examples of the device are: (i) anode / emission layer / cathode; (ii) anode / hole transport layer / emission layer / cathode; (iii) anode / hole transport layer / electron transport layer / cathode; (iv) anode / hole injection layer / hole transport layer / emission layer / cathode; (v) anode / hole injection layer / hole transport layer / emission layer / electron transport layer / cathode; (vi) anode / hole injection layer / hole transport layer / emission layer / electron transport layer / electron injection layer / cathode; and (vii) anode / hole injection layer / emission layer / electron injection layer / cathode, etc. A hole blocking layer may also optionally be placed between the emission layer and the electron transport layer. In one embodiment, a device having the above structures is supported by a substrate. No particular limitation exists for the substrate, and any conventional substrate may be used in the organic EL device, such as glass, transparent plastics, quartz, etc.

Each layer constructing the organic EL device of the present invention can be formed by applying the materials using conventional methods such as deposition methods, spin-coat methods, or cast methods, to apply the layers.

No particular limitation exists on the thickness of each layer, such as the emission layer, formed by such methods, and a suitable selection may be made depending on the desired conditions of the device.

In addition, for the anode of the organic EL device, a metal having a work function of more than 4.0 eV, alloy, electric-conductive compound, or combinations thereof, can be used as electrode. Non-limiting examples of such electrode materials are electric conductive transparent or non-transparent materials, such as ITO, SnO₂, ZnO, Au, etc. The anode can be manufactured by forming a thin film through deposition methods, sputtering methods, etc.

Besides, for the cathode of the organic EL device, a metal having a work function of less than 4.2 eV, alloy, electric-conductive compound, or combination thereof, can be used as electrode. Non-limiting examples of such electrode materials are calcium, magnesium, lithium, aluminum, magnesium alloy, lithium alloy, aluminum alloy, aluminum/lithium mixture, magnesium/silver mixture, indium, etc.

The cathode also can be manufactured by forming a thin film through deposition methods, sputtering methods, etc. Preferably, the sheet resistance of the electrode is less than several hundreds Ω/mm, and the thickness of the film is selected from the range of 10 nm to 1 µm, preferably 50 to 200 nm.

Any material conventionally used as a hole transport material among photoconductive materials and any random material among known materials used as a hole injection layer or a hole transport layer can be used as materials for the hole injection layer and the hole transport layer in the organic EL device of the present invention.

For the organic EL device of the present invention, the electron transport layer comprises an electron transport compound, and has a role of transporting electrons injected from the cathode to the emission layer. No particular limitation exists for such an electron transport compound, and any conventionally known compound can be selected therefor.

One embodiment of a suitable method to manufacture the organic EL device of the present invention having the above six (vi) structures is explained as follows:

First, a first electrode (2) is formed on a transparent substrate (1), for example, by using sputtering method. Then, a hole injection layer (3) and a hole transport layer (4) are formed thereon in order by deposition in a vacuum. After that, an organic emission layer (5) and an electron transport layer (6) are formed on the hole transport layer (4), and an electron injection layer (7) and a cathode (8) are formed on the electron transport layer (6).

The emission layer (5) can be formed with a conventional host doped with one or more dopants of formula (I) of the present invention, or by only the compounds of formula (I) of the present invention. In addition, the compounds of formula (I) of the present invention can be formed as the emission layer by using each other as host and dopant.

ITO (In₂O₃+SnO₂) or IZO (In₂O₃+ZnO) can be used for the material of the anode (2), and copper (II) phthalocyanine can be used for the material of the hole injection layer. Triphenylamine or diphenyl amine analogues such as NPD (N,N-di(naphthalen-1-yl)-N,N'-diphenylbenzidine) can be used for the material of the hole transport layer (4), and Alq3 (tris(8-hydroxyquinolate)aluminum) can be used for the host material of the emission layer (5). In addition, Alq3 can also be used for the electron transport layer (6) due to good electron transport property, and oxadiazole or triazole analogues such as 2-(4-bi-phenyl)-5-(4-tert-butylphenyl)-1,3,4-oxadiazole can also be used for the electron transport layer (6). Alkali metal (Cs, Rb, K, Na, Li) analogues (Li₂O, etc.) can be used for the electron injection layer (7), and Mg/Ag, Al, Al/Li, or Al/Nd can be used for the cathode (8).

The synthetic examples of the compounds of formula (I) of the present invention, and the organic EL device applied with the compounds are explained through the synthetic examples and practicing examples below. However, the scope of the present invention is not limited by the following Examples, and it should be noted that various modifications can be made by a skilled person in the art within the scope of the present invention.

### Synthesis of Compound 1

2-aminophenol (8.66g) and calcium carbonate (3.87g) are dissolved in dimethylformamide (27.63ml), to which 1-chloro-3-methyl-2-butene (18.32ml) is added, The mixture is reacted at 80□ to obtain 8.25g of a compound of formula (2). Methanesulfonic acid (9.5ml, 5 times mol basis of the compound of formula (2) used), is added to the compound of formula (2) (8.25g), which is reacted at 100□. After that, the solution is neutralized by using water and sodium hydroxide to obtain a compound of formula (3) (6.78g). Phosphorus oxychloride (4.12ml) and dimethylformamide (11.8g) are added to the obtained compound of formula (3) (6.78g), which is reacted to obtain a compound of formula (4) (5.64g). Ethanol (36g) and piperidine (0.3ml) are added to the compound of formula (4) (5.64g) and a compound of formula (5) (2-acetonitrile-benzotriazole) (3.82g), and the solution was stirred. After confirming that the reaction was completed by the TLC (thin layer chromatography), the solution was neutralized by using a suitable amount of HCl to obtain a compound of formula (6). And then, water and sodium hydroxide are added to the obtained compound of formula (6), which is reacted to obtain a compound of formula (7) (3g). And, NaCN (sodium cyanide, 0.55g), Br₂ and DMF are added to the compound of formula (7) (3g), which is reacted to obtain Compound 1 (1.5g). 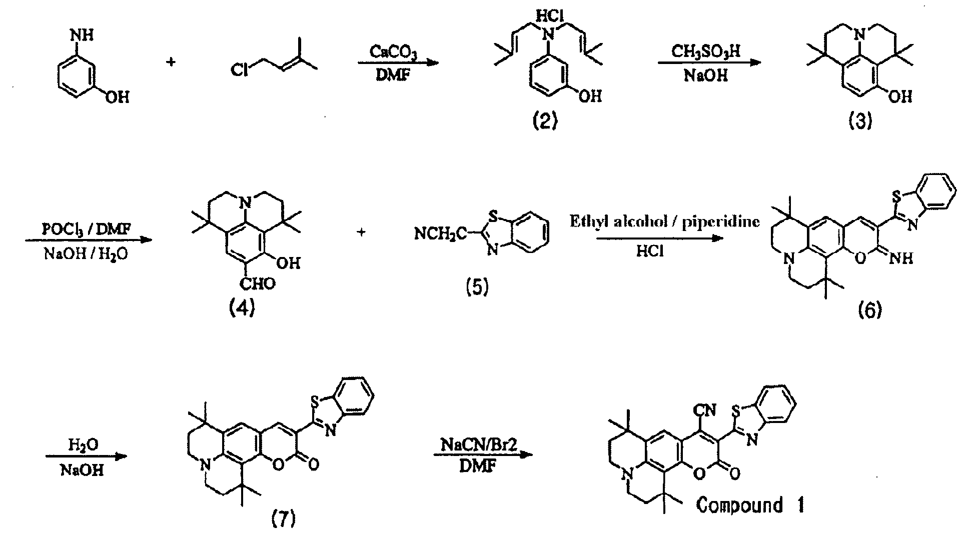 Compound 1: NMR Analysis (¹H NMR(CDCl₃): CH₂(4H, 1.77, d), CH₂(4H, 3.35, d), CH₂(12H, 1.39, s), PH(1H, 7.28, s), PH(1H, 8.12, d), PH(1H, 8.23, d), PH(2H, 7.55, m).

### Example

This example is one to manufacture the organic EL device by using Alq3 as a host, and Compound 1 prepared by the above method as a dopant of a red color emitting layer.

First, a hole injection layer was formed with a thickness of 30nm by depositing CuPC in a vacuum on an ITO-deposited glass washed by a microwave. After the hole transport layer was formed with a thickness of 50nm by depositing NPD (N,N'-dinaphthyl-N,N'- phenyl-(1,1'-biphenyl)-4,4'-diamine) on the top of the hole injection layer, an emission layer was formed with a thickness of 30nm on the hole transport layer by depositing Alq3 (host), which was doped with Compound 1 (dopant) by 2.0%. An electron transport layer (Alq3; 40nm), an electron injection layer (Li₂O; 25 nm), and a cathode (Mg/Ag; 100 nm) were formed in this order thereon by depositing in a vacuum to complete the organic EL device.

A direct voltage of forward bias was applied to the organic EL device manufactured by this example, and its luminescent property was evaluated. The luminescent color was red. The result of a voltage-brightness test showed 2.4cd/A of brightness at 8.0V, at which point the efficiency was 1.10 lm/W (see Table 1) The values were measured by the machine, MINOLTA CS-1000(measurement standard: 50mA/cm²).

### Comparative example

Comparative Example 1 manufactured an organic EL device using Alq3 as a host and DCJTB as a dopant of the red color emitting layer.

First, a hole injection layer was formed with a thickness of 30nm by depositing CuPC in a vacuum on an ITO-deposited glass washed by a microwave. Then, a hole transport layer was formed with a thickness of 50nm by depositing NPD (N,N'-di(naphthylen-1-yl)-N,N'-diphenylbenzidine) on the top of the hole injection layer, and an emission layer was formed with a thickness of 30nm on the hole transport layer by depositing Alq3 (host), which was doped with DCJTB (dopant) by 2.0%. An electron transport layer (Alq3; 40nm), an electron injection layer (Li₂O; 25 nm), and a cathode (Mg/Ag; 100 nm) were formed in this order thereon by depositing in a vacuum to complete the organic EL device.

A direct voltage of forward bias was applied to the organic EL device manufactured by this comparative example, and its luminescent property was evaluated. The luminescent color was red. The result of a voltage-brightness test showed 1.95cd/A of brightness at 8.46 V, at which point the efficiency was 0.73 lm/W.

The results of the Example and Comparative example are summarized in Table 1 below.

**[Table 1]**

| | **Host** | **Dopant** | **Applied Voltage (V)** | **Color coordinates** | | **Brightne ss (cd/ A)** | **Efficie ncy (lm/W)** |
|---|---|---|---|---|---|---|---|
| | | | | **X** | **Y** | | |
| Example 1 | Alq 3 | Compound 1 | 8.0 | 0.636 | 0.354 | 2.4 | 1.10 |
| Comparative Example 1 | Alq 3 | DCJTB | 8.46 | 0.639 | 0.357 | 1.95 | 0.73 |

As shown in the above table, an organic EL device prepared with the red color emitting material of the present invention shows high advanced luminescent efficiency and brightness compared to an organic EL device prepared with a conventional red color emitting material. In addition, the present materials contribute to enhanced safety and lifetime of the device.

## Claims

1. A compound represented by the following formula (1): 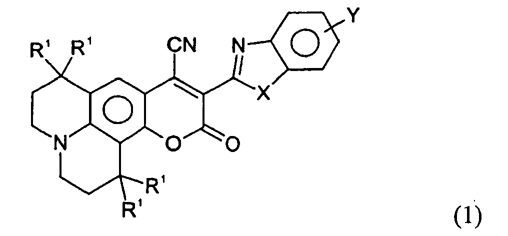 Wherein,
R¹ is independently selected from the group consisting of hydrogen atom and substituted or unsubstituted C₁₋₆alkyl;
X represents N, S, or O; and
Y represents hydrogen atom, substituted or unsubstituted C₁₋₆alkyl, or substituted or unsubstituted C₁₋₆alkoxy.

2. The compound according to claim 1, wherein R¹ is methyl.

3. The compound according to claim 1 or 2, wherein X is S.

4. The compound according to any one of claims 1 to 3, wherein the compound is a red color emitting material.

5. An organic electroluminescent device, comprising:
a first electrode;
one or more organic layers including emitting layer; and
second electrode;
wherein the organic layers exist between the first electrode and the second electrode, and at least one of the organic layers contains one or more compounds represented by the formula (1) according to any one of claims 1 to 3.

6. The device according to claim 5, wherein one or more compounds represented by the formula (1) according to any one of claims 1 to 3 are used as dopant and/or host material.
